# EUROPÄISCHE PATENTANMELDUNG

(11) **EP 2 378 847 A2**
(43) Veröffentlichungstag der Anmeldung: **19.10.2011**
(21) Anmeldenummer: 11162019.1
(22) Anmeldetag: 12.04.2011
(51) Int. Cl.: H05K 5/02

(54) **Intumeszenzbeschichtung in elektronischen Steuergeräten zur Brandvermeidung/Verzögerung**

(30) Priorität: 15.04.2010 DE 102010027760
(71) Anmelder: Robert Bosch GmbH, 70442 Stuttgart (DE)
(72) Erfinder: Wolf, Joerg, 76139, Karlsruhe (DE)

(57) **Zusammenfassung**

Elektronische Komponente oder Steuergerätgehäuseteil (4), welches mit einer Intumeszenzbeschichtung (12) beschichtet ist, die bei einer wählbaren Grenztemperatur TG auf das Vielfache ihrer ursprünglichen Dicke aufquillt und zu einer porösen und isolierenden Schutzschicht mit geringer Wärmeleitfähigkeit aushärtet, wodurch es bei einem Brand zu einer Wärmeisolation als auch eines Sauerstoffentzugs im betroffenen Bereich kommt und ein Ausbreiten des Brandes vermieden beziehungsweise verzögert wird.

## Beschreibung

### Stand der Technik

Bekannt sind Intumeszenzbeschichtung, die sich sich bei erhöhten Temperaturen zu einem thermisch stabilen, multizellularen thermisch isolierenden Schutzfilm aufblähen.

DE 35 46 403 C2 offenbart ein Wärmeschutzgehäuse zum Schutz von Vorrichtungen oder Baugruppen vor schädlichen beziehungsweise zerstörenden hohen Umgebungstemperaturen und insbesondere Wärmeschutzgehäuse, bei denen Größe und Gewicht eine große Rolle spielen. Das Wärmeschutzgehäuse umfasst ein Außengehäuse, eine Wärmeschutzauskleidung und einen Wärmeisolator in dem die wärmeempfindlichen Gegenstände teilweise oder vollständig eingebettet sind und der bei einer vorgegebenen Temperatur einen Fest-Fest-Phasenübergang aufweist, wenn das Wärmeschutzgehäuse hohen Umgebungstemperaturen ausgesetzt ist.

EP 2 061 126 A2 offenbart eine Brandschutz-Kabeldurchführung zur Abschottung von Wand- oder Deckendurchbrüchen für Kabel, Rohre oder ähnlichen Elementen und weist ein beidseitig geöffnetes Gehäuse mit einem Kabelkanal bildenden Innenraum auf. In diesem Kabelkanal befinden sich mindestens zwei Brandschutzstreifen aus intumeszentem Brandschutzmaterial, die bei großer Wärme den Innenraum des Gehäuses im wesentlichen vollständig in Kabelrichtung abschotten.

EP 2 096 346 A2 offenbart eine Leitungsdurchführung zum Durchführen von Leitungen durch ein Bauteil mit einem umfänglich geschlossenen Gehäuse, das einen Durchführraum für die Leitungen umgibt, wobei im Gehäuse eine Einlage aus intumeszierendem Material sowie ein erstes, membranartiges und mit einer Durchtrittsstelle versehenes, Dichtelement aus einem elastischen Material vorgesehen sind.

US 6,410,137 B1 offenbart ein brandhemmendes Material zur Abschirmung elektromagnetischer Interferenzen. Dabei ist eine elektrisch leitende Schicht auf einer oder beiden Seiten von einer intumeszierenden, druckempfindlichen Klebstoffschicht begrenzt.

DE 36 33 257 A1 offenbart ein metallisiertes, textiles Flächengebilde mit einer teil- oder vollflächige Beschichtung aus einem intumeszierenden flexiblen Material, insbesondere Gewebe für die Schirmdämpfung elektromagnetischer Strahlung im Bereich von 1 MHz bis 1000 GHz bei Gegenständen, insbesondere elektrischen und elektronischen Geräten und Bauteilen, sowie Räumen.

All diese Umbauungen oder Beschichtungen zur Brandvermeidung beziehungsweise Brandverzögerung besitzen den Nachteil, dass sie einen relativ hohen Platzbedarf besitzen und das Auf- oder Anbringen technisch als auch zeitlich mit großem Aufwand verbunden ist. Außerdem ist ein nachträgliches Anbringen der brandhemmenden Beschichtung nicht, oder nur sehr umständlich, möglich.

US 6,548,753 B1 offenbart ein Gehäuse, speziell zur Brandunterdrückung, für elektrische Bauelemente. Dazu ist eine perforierte Deckplatte eines Gehäuse, die zur Belüftung dient, mit einem intumeszierendem Material beschichtet. Bei erhöhten Temperaturen dehnt sich dieses intumeszierende Material aus und dichtet damit die Perforationen ab. Dadurch wird ein Luftzug, der den Brand weiter ausbreiten würde, unterbunden und es wird gleichzeitig verhindert, dass Luftsauerstoff an die Brandstelle gelangt.

US 6,549,422 B1 offenbart eine Vorrichtung zur Eindämmung und Unterdrückung von Bränden in elektronischen Systemen, umfassend eine Führungsschiene für beispielsweise Leiterplatten, mit mindestens einer intumeszierenden lackbeschichteten Apertur. Ab einer bestimmten Temperatur expandiert der intumeszierende Lack, dadurch schließen sich die Öffnungen der Apertur und die brandverursachende Leiterplatte wird luftdicht abgeschlossen.

US 6,130,381 offenbart ebenfalls ein Gehäuse für elektronische Bauelemente mit einem Gitter, das mit einem intumeszierenden brandhemmenden Anstrich beschichtet ist. Im Fall eines Brandes und der damit einhergehenden erhöhten Temperaturen expandiert dieser intumeszierende Anstrich und die Luftzufuhr wird unterbunden.

Diese Art der Lack-Beschichtung ist sehr viel einfacher durchzuführen als das extra Anbringen einer brandhemmenden Beschichtung. In allen drei Fällen ist jedoch die Beschichtung nur partiell und dient dazu, lokal die Luftzufuhr zu unterbinden. Die Brandstelle ist nicht vollständig umschlossen, so daß immer noch Sauerstoff an den Brandherd gelangt und das Feuer weiter getragen werden kann. Es kommt also bestenfalls nur zu einer Verzögerung der Brandausbreitung, nicht zu einer Erstickung.

### Offenbarung der Erfindung

Die Gehäuse elektronischer Steuergeräte werden vermehrt aus Thermoplasten hergestellt. Auf Grund der erhöhten Komplexität und Integrationsdichte der Leistungselektronik bei steigender Medienbelastung wächst das Risiko eines Kurzschlusses mit daraus folgendem Brand im Steuergerät. Dieser steuergeräteinterne Brand entzündet die relativ leicht brennbaren Thermoplastgehäuse mit unter Umständen gravierenden Folgen.

In der Bauindustrie werden zum Brandschutz von tragenden Teilen (Holz- bzw. Strahlträgern) Intumeszenzbeschichtungen (aufquellende Beschichtungen) eingesetzt, die, aufgetragen wie eine Lackschicht, bei Brandbelastung auf das zum Teil 10fache ihrer Ausgangsstärke anwachsen und eine nicht brennbare Schicht bilden. Hierdurch behalten die Holz- und/oder Stahlkonstruktionen ihre Festigkeit und ein Einsturz der brennenden Gebäude wird vermieden oder mindestens signifikant verzögert.

Derartige Intumeszenzbeschichtungen sind in der Regel elastische Beschichtungsmaterialien und dienen als Isolationsmaterialien bei Hochtemperaturanwendungen. Sie bestehen vorzugsweise aus einem elastischen Bindemittel und einer anorganischen Füllstoffkombination. Bei Einwirkung hoher Temperaturen, wie sie unter anderem bei direkter Flammen- und Hitzeeinwirkung und heißen Gasströmungen entstehen, reagieren die hochschmelzende Füllstoffe mit dem Bindemittel aus Polymeren und es bildet sich eine zusammenhängende, poröse und isolierende Schutzschicht aus, die hohen Gasströmungen widersteht und so, je nach Material, minuten- bis stundenlangen Schutz vor Brand bieten.

Die ausgebildete Schutzschicht besitzt durch ihre Porosität eine deutlich geringere Wärmeleitfähigkeit als die von ihr umgebenen, zu schützenden Komponenten. Durch die Unbrennbarkeit der polymeren Trägermatrix wird zudem eine Wärmekonvektion und eine Brandausbreitung vermieden.

Durch Zusatzstoffe im Beschichtungslack ist es möglich, die Aufquellung der Dämmschicht bereits bei wenigen 100°C zu aktivieren.

Überraschenderweise konnte gezeigt werden, dass Beschichtungen dieser Art auch auf Kunststoffen haften und ein Entzünden zuverlässig verhindern beziehungsweise zumindest verzögern.

Die Anwendung von Intumeszenzbeschichtung in Steuergerätegehäusen, und gegebenenfalls zusätzliche Beschichtung von bestückten Schaltungsträgern, verhindert idealerweise den Brandaustritt aus dem Steuergerät, beziehungsweise verzögern diesen solange bis eine interne thermische Sicherung (Thermosicherung/Thermofuse) auslösen kann.

Eine Thermosicherung dient zur Abschaltung eines Stromkreises bei Übertemperatur. Temperatursicherungen sind nahe an oder in den zu überwachenden elektronischen Komponenten untergebracht und besitzen eine elektrische Verbindung, die über ein, bei einer definierten Temperatur schmelzendes, Metall realisiert ist. Wird eine Temperatur TS überschritten, schmilzt das Metall, eine Lötverbindung wird, beispielsweise über eine Feder, geöffnet und die Energiezufuhr des Steuergerätes dadurch unterbunden.

Die Beschichtungen von Schaltungsträgern, beispielsweise bestückten Leiterplatten, in denen ein Kurzschluss mit Brandfolge möglich ist, halten den Brandverlauf im Schaltungsträger und vermindern das Risiko der Entzündung des restlichen Steuergerätes.

Durch die aufgequollene und ausgehärtete Schicht kann zum einen bedeutend weniger Luftsauerstoff an die elektronischen Komponenten oder den Schaltungsträger gelangen und zum andern wird durch diese Dämmschicht eine Ausbreitung des Brandes auf benachbarte elektronische Komponenten und nach außen hinaus vermieden.

Vorteile gegenüber anderen brandhemmenden Beschichtungen von Bauteilen sind zum einen die geringe Dicke des Schutzfilms (Größenordnung Mikro- bis Millimeter), der erst im Bedarfsfall auf seine wirksame Dicke aufquillt und die poröse und isolierende Schicht ausbildet. Die Abmessungen der elektronischen Komponenten oder der Steuergerätgehäuseteile sind dadurch nur unwesentlich erhöht, was eine effiziente Bestückung von Steuergräten erlaubt und eine Gewichtseinsparung mit sich bringt.

Die verwendete Intumeszenzbeschichtung ist zudem elastisch und kann Dehnbewegungen des Trägermaterials folgen, was sich sowohl bei der Bestückung als auch während des Betrieb als vorteilhaft erweisen kann.

Darüber hinaus zeichnet sich die verwendete Intumeszenzbeschichtungen durch einstellbare mechanische Eigenschaften, wie Aufquelldicke, Reißfestigkeit, Dehnvermögen und Steifigkeit, als auch Temperatur bei der das Aufschäumen der porösen und isolierenden Schicht bei Flammen- und Hitzeeinwirkung eintritt, aus.

### Kurze Beschreibung der Zeichnungen

Anhand der Zeichnungen wird die Erfindung nachstehend eingehender beschrieben.

Es zeigen:
- Figur 1: Ein mit einem Intumeszenzbeschichtungsstoff überzogenes Steuergerätegehäuseteil im Neuzustand,
- Figur 2: Eine Seitenansicht einer mit einer Intumeszenzschicht beschichteten Holzplatte,
- Figur 3: Eine Seitenansicht der in Figur 2 dargestellten, mit einer Intumeszenzschicht beschichteten, Holzplatte mit hoher Aufquellung nach 10 minütiger Beflammung durch eine runde Maske mit einem Gasbrenner,
- Figur 4: Eine Seitenansicht einer mit einer Intumeszenzschicht beschichten Polyamid (PA6)-Platte nach 10 minütiger Beflammung durch eine runde Maske mit einem Gasbrenner und
- Figur 5: Ein Diagramm des Temperaturverlaufs auf der Rückseite einer unbeschichteten beziehungsweise mit einer Intumeszenzschicht beschichten Polyamid (PA6)-Platte während der Gasbrenner-Beflammung.

### Ausführungsvarianten

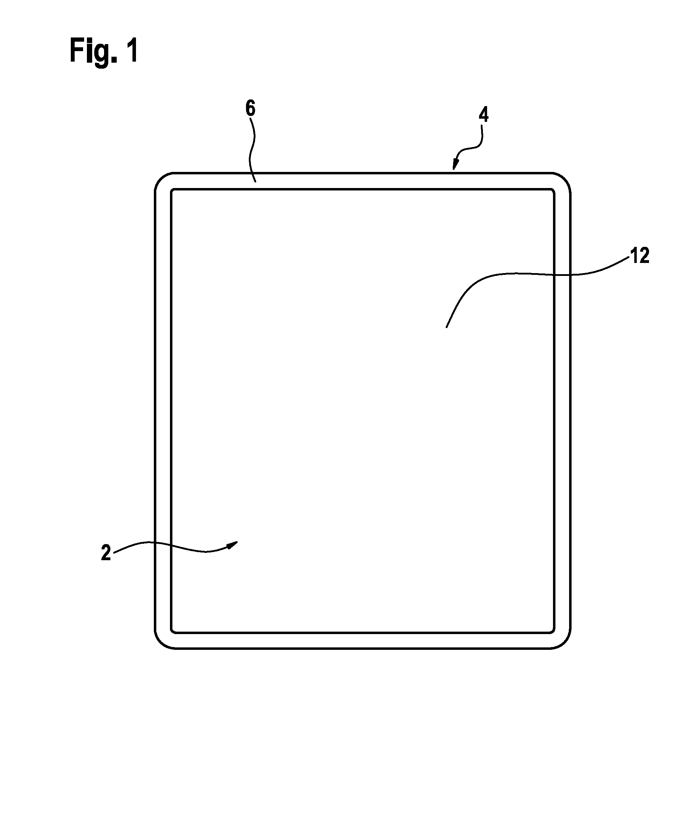

Figur 1 zeigt ein mit einem Intumeszenzbeschichtungsstoff 12 überzogenes Steuergerätegehäuseteil 4 im Neuzustand.

Auf einer Innenseite 2 eines Steuergerätegehäuseteil 4 wird ein flüssiger oder pulverförmiger Intumeszenzbeschichtungsstoff, durch beispielsweise Lackieren, Spritzen, Sputtern, Dispensieren, oder eine ähnliche Techniken, aufgetragen.

In ebenen Flächen mit einem umlaufendem Rand 6, beispielsweise einem Deckel, kann diese Intumeszenzbeschichtung 12 auch durch ein Gießverfahren erfolgen.

Der Überzug eines bestückten Schaltungsträgers oder eines Steuergerätegehäuses mit flüssigem oder pulverförmigem Intumeszenzbeschichtungsstoff erfolgt vollflächig oder nur partiell.

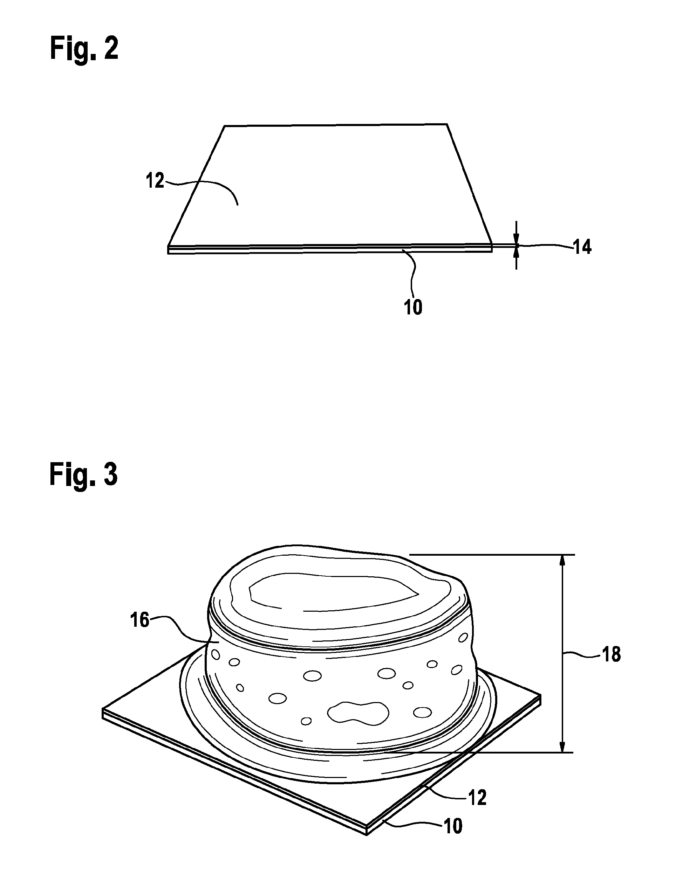

Zur Verdeutlichung der Erfindung ist in Figur 2 beispielhaft eine Holzplatte 10 mit einer Intumeszenzbeschichtung 12 bei Raumtemperatur mit einer Schichtdicke 14 dargestellt.

Vorzugsweise beträgt die Schichtdicke 14 im Ausgangszustand der Intumeszenzbeschichtung 12 zwischen 200pm und 2mm, wobei die Zusammensetzung der Intumeszenzbeschichtung 12 aus Bindemittel, anorganischen Füllstoffen in Pulverform oder aus kurzen Fasern, beispielsweise Glassfaser verstärktem Kunststoff, und Phosphorsäureester zum Aufquellen der Schicht, unterschiedlich sein kann.

Die Bindemittel umfassen PU(B), Silikonkautschuke(A), Silikonharze, Phenolharze, Melaminharze, Epoxy-Harze, Polyvinylacetat, Harnstoff-Aldehydharz und/oder Polyurea-Harz.

Anorganische Füllstoffe umfassen Siliciumdioxid, Siliciumcarbid, Titandioxid, Natriumborat, Zinkborat und/oder Natriumphosphat.

Spezialanwendungen, beispielsweise besonders hohe Temperaturen oder besonders lange Schutzzeiten, können durch geeignete Wahl von Bindemittel und anorganischen Füllstoff realisiert werden.

In Figur 3 ist die in Figur 2 gezeigte, mit der Intumeszenzbeschichtung 12 versehene, Holzplatte 10 nach 10 minütiger Beflammung durch eine runde Maske mit einem Gasbrenner dargestellt.

Die Intumeszenzbeschichtung 12 von nur einigen Millimetern Dicke 14 ist auf eine Schicht, von nun an als Schutzschicht 16 bezeichnet, mit einer Dicke 18 von mehreren Zentimetern aufgequollen.

Die Intumeszenzbeschichtung 12 quillt erst im Bedarfsfall auf ihre wirksame Dicke 18 auf. Die Abmessungen der beschichteten elektronischen Komponenten oder der Steuergerätgehäuseteile 4 sind dadurch nur unwesentlich erhöht, was eine effiziente Bestückung von Steuergräten erlaubt und eine Gewichtseinsparung gegenüber normalerweise verwendeten nicht-brennbaren Vergussteilen oder brandhemmenden Lacken mit sehr viel Schichtdicken mit sich bringt.

Die verwendete Intumeszenzbeschichtung 12 zeichnet sich durch einstellbare zähelastische mechanische Konsistenz mit hoher Reißfestigkeit (zwischen 1,5-10 N/mm², bei 20 °C), gutem Dehnvermögen (Reißdehnung zwischen 10-80 %, bei 20 °C), variabler Steifigkeit (Elastizitätsmodul zwischen 5-100 N/mm², bei 20 °C) und variable Aufquelldicke (30-120 fache der Ausgangsschichtdicke) aus. Dadurch ist eine genaue Anpassung der Intumeszenzbeschichtung 12 an die erwarteten Umweltbedingungen möglich, was zu einem leistungsfähigeren und sicheren System führt.

Wird beispielsweise in einem Steuergerät eine Grenztemperatur TG überschritten, reagieren hochschmelzende Füllstoffe, wie beispielsweise Siliziumcarbid und Siliziumdioxid, mit einem Bindemittel aus Polymeren, was zu einem Aufquellen der Intumeszenzbeschichtung 12 auf das circa 30 bis 120-fache der ursprünglichen Schichtdicke 14 führt. Die Schutzschicht 16 verfestigt sich unmittelbar nach dem Aufquellen mit den Füllstoffen zu einem porösen und isolierenden Material.

Sinnvollerweise liegt die einstellbare Grenztemperatur TG, ab der ein Aufquellen der Intumeszenzschicht 12 beginnt, für ein Steuergerät bei circa 300°C, so dass kein selbstständiges Auslösen des Aufquellvorgangs durch eine erhöhte Betriebstemperatur des Steuergerätes erfolgen kann.

Die Intumeszenzbeschichtung 12 zehrt sich nur langsam auf. Daher wird durch das Aufquellen der Intumeszenzbeschichtung 12 ein Brand wirksam eingedämmt, so stoppt der Aufquellvorgang und der nicht aufgequollene Teil der Intumeszenzbeschichtung 12 steht weiterhin zur Brandvermeidung zur Verfügung.

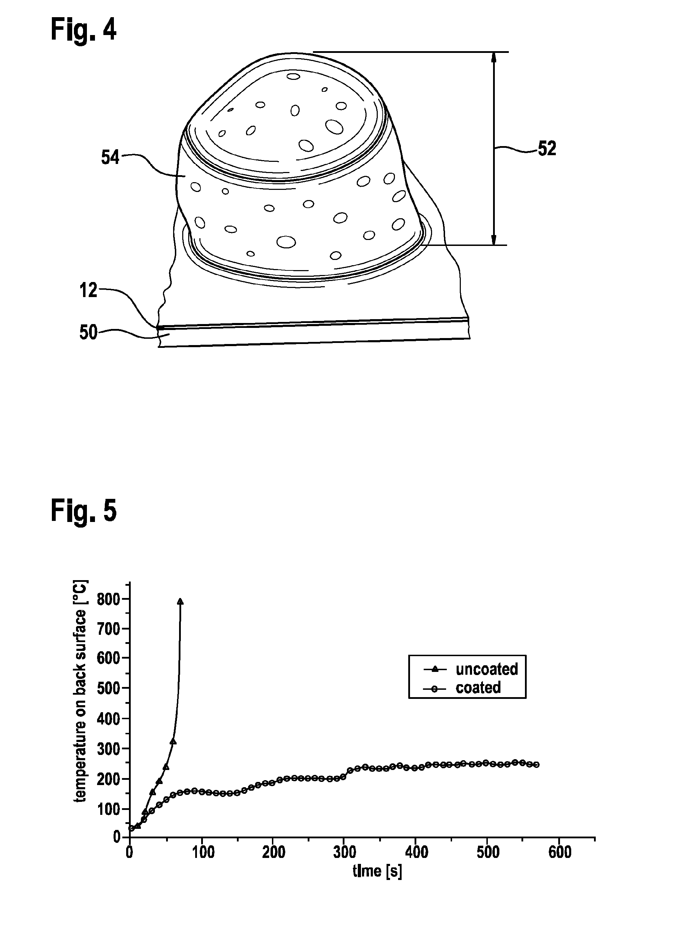

In Figur 4 ist eine, mit einer Intumeszenzschicht 12 beschichtete, Polyamid (PA6) Platte 50 nach 10 minütiger Beflammung durch eine runde Maske mit einem Gasbrenner gezeigt.

Die ursprünglich aufgebrachte Intumeszenzbeschichtung 12 ist nach der Hitzeeinwirkung auf eine Schutzschicht 54 mit der Dicke 52 aufgequollen.

Durch das Aufquellen der nicht brennbaren isolierenden Schutzschicht 16 (Figur 3) beziehungsweise 54 (Figur 4) wird der Brand, beispielsweise ein Schaltungsträger oder in einem Steuergerät, eingedämmt beziehungsweise mindestens verzögert um die Thermosicherung zuverlässig auszulösen zu können.

Die ausgebildete Schutzschicht 16 (Figur 3) beziehungsweise 54 (Figur 4) besitzt durch ihre Porosität eine deutlich geringere Wärmeleitfähigkeit als die von ihr umgebenen, zu schützenden Komponenten. Durch die Unbrennbarkeit der polymeren Trägermatrix wird zudem eine Wärmekonvektion und eine Brandausbreitung vermieden.

Die entstehende voluminöse Schutzschicht 16 (Figur 3) beziehungsweise 54 (Figur 4) vermindert außerdem die Zufuhr von Luftsauerstoff und wirkt somit branderstickend.

Dieser Effekt ist in Figur 5 dargestellt, die ein Diagramm eines Temperaturverlaufs auf der Rückseite 56 einer unbeschichteten beziehungsweise mit einer Intumeszenzschicht beschichten Polyamid (PA6)-Platte 50 (siehe Figur 4) während der Gasbrenner-Beflammung zeigt.

Bei einer unbeschichteten Polyamid (PA6)-Platte (nicht dargestellt) steigt die Temperatur während der Beflammung auf der Rückseite der Platte exponential an und überschreitet bereits nach weniger als 60 Sekunden die 300°C Marke beziehungsweise beträgt nach 100 Sekunden bereits 800°C.

Wird eine werkstoffgleiche Polyamid (PA6)-Platte 50 mit einer Intumeszenzschicht 12 beschichtet und beflammt, so steigt die Temperatur nur logarithmisch auf einen Plateauwert an. Nach 60 Sekunden beträgt die Temperatur der Rückseite 56 der Platte 50 circa 125°C und nach 100 Sekunden circa 150°C. Danach steigt die Temperatur nur noch geringfügig an und liegt auch nach 10 Minuten bei circa 200°C. Diese Temperatur liegt unter dem Flammenpunkt beziehungsweise Erweichungspunkt der Polyamid (PA6)-Platte 50. Eine Entzündung der Polyamid (PA6)-Platte 50, sowie ein Aufbrechen der Polyamid (PA6)-Platte 50, und damit ein Durchschlagen der Flammen, wird daher wirksam verhindert.

Polyamide beginnen sich bei Temperaturen >300°C langsam zu zersetzen. Im Temperaturbereich von 450°C bis 500°C bilden sich brennbare Gase, die nach einer Zündung weiter brennen. Ein Steuergerät aus unbeschichtetem PA6 wäre also bereits nach weniger als 100 Sekunden komplett unbrauchbar und eine Gefahr für umliegende Bauelemente, während einem Steuergerät mit einer Intumeszenzschicht genügend Zeit zum Auslösen der internen thermischen Sicherung und damit zum Schutz des Steuergerätes und der umliegenden Bauelemente bleibt.

Die Temperatur TG, bei der das Aufquellen der Intumeszenzbeschichtung bei Flammen- und Hitzeeinwirkung eintritt, ist einstellbar.

Je nach Ausgangsdicke der Intumeszenzbeschichtung kann die elektronische Komponente oder das Steuergerätgehäuseteil 4 bei Temperaturen bis 1000°C über mehrere Stunden, beziehungsweise minutenlang bei Temperaturen bis 2000°C, geschützt werden.

## Patentansprüche

1. Elektronische Komponente oder Steuergerätgehäuseteil (4), **dadurch gekennzeichnet, daß** die elektronische Komponente oder das Steuergerätgehäuseteil (4) mit einer porösen und isolierenden, bei einer Temperatur TG expandierenden, Intumeszenzbeschichtung beschichtet ist.

2. Elektronische Komponente oder Steuergerätgehäuseteil (4), nach Anspruch 1, **dadurch gekennzeichnet, daß** die Temperatur TG einstellbar ist.

3. Steuergerätgehäuseteil (4), nach Anspruch 1, **dadurch gekennzeichnet, daß** das Steuergerätgehäuseteil (4) ein vollständiges Steuergerät ist.

4. Elektronische Komponente, nach Anspruch 1, **dadurch gekennzeichnet, daß** die elektronische Komponente ein Schaltungsträger ist.

5. Elektronische Komponente oder Steuergerätgehäuseteil (4), nach einem oder mehreren der vorhergehenden Ansprüche, **dadurch gekennzeichnet, daß** die elektronische Komponente oder das Steuergerätgehäuseteil (4) vollflächig mit einer porösen und isolierenden Intumeszenzbeschichtung beschichtet ist.

6. Elektronische Komponente oder Steuergerätgehäuseteil (4), nach einem oder mehreren der vorhergehenden Ansprüche, **dadurch gekennzeichnet, daß** die elektronische Komponente oder das Steuergerätgehäuseteil (4) partiell mit einer porösen und isolierenden Intumeszenzbeschichtung beschichtet ist.

7. Elektronische Komponente oder Steuergerätgehäuseteil (4), nach einem oder mehreren der vorhergehenden Ansprüche, **dadurch gekennzeichnet, daß** die Ausgangsschichtdicke der porösen und isolierenden Intumeszenzbeschichtung vorzugsweise zwischen 200µm und 2mm ist.

8. Elektronische Komponente oder Steuergerätgehäuseteil (4), nach einem oder mehreren der vorhergehenden Ansprüche, **dadurch gekennzeichnet, daß** die poröse und isolierende Intumeszenzbeschichtung vorzugsweise einen anorganischen Füllstoff enthält.

9. Elektronische Komponente oder Steuergerätgehäuseteil (4) nach Anspruch 8, **dadurch gekennzeichnet, dass** der organische Füllstoff Siliciumdioxid, Siliciumcarbid, Titandioxid, Natriumborat, Zinkborat und/oder Natriumphosphat umfasst.

10. Elektronische Komponente oder Steuergerätgehäuseteil (4), nach einem oder mehreren der vorhergehenden Ansprüche, **dadurch gekennzeichnet, daß** die poröse und isolierende Intumeszenzbeschichtung ein Bindemittel umfassend PU(B), Silikonkautschuke(A), Silikonharze, Phenolharze, Melaminharze, Epoxy-Harze, Polyvinylacetat, Harnstoff-Aldehydharz, Polyurea-Harz enthält.

11. Elektronische Komponente oder Steuergerätgehäuseteil (4) nach Anspruch 10, **dadurch gekennzeichnet, daß** das Bindemittel PU(B), Silikonkautschu-ke(A), Silikonharze, Phenolharze, Melaminharze, Epoxy-Harze, Polyvinylacetat, Harnstoff-Aldehydharz und/oder Polyurea-Harz enthält.

12. Elektronische Komponente oder Steuergerätgehäuseteil (4), nach einem oder mehreren der vorhergehenden Ansprüche, **dadurch gekennzeichnet, daß** die poröse und isolierende Intumeszenzbeschichtung Phosphorsäureester zum Aufquellen der Schicht enthält.

13. Verfahren zur Beschichtung einer elektronischen Komponente oder eines Steuergerätgehäuseteils (4) mit einer porösen und isolierenden Intumeszenzbeschichtung.
